(19) Europäisches Patentamt
European Patent Office
Office européen des brevets

(11) **EP 3 901 641 B1**

(12) **EUROPEAN PATENT SPECIFICATION**

(45) Date of publication and mention
of the grant of the patent:
**08.05.2024   Bulletin 2024/19**

(21) Application number: **21168746.2**

(22) Date of filing: **16.04.2021**

(51) International Patent Classification (IPC):
**H02J 7/00** $^{(2006.01)}$   **G01R 27/02** $^{(2006.01)}$
**H02J 3/32** $^{(2006.01)}$   **H02J 3/00** $^{(2006.01)}$

(52) Cooperative Patent Classification (CPC):
**H02J 7/0029; G01R 27/025;** H02J 3/001;
H02J 3/322; H02J 7/0063; H02J 2310/48;
Y02T 10/70; Y02T 10/7072; Y02T 90/167;
Y04S 30/12

(54) **INSULATION IMPEDANCE DETECTION CIRCUIT FOR ON-BOARD CHARGER AND INSULATION IMPEDANCE DETECTION METHOD**

ISOLATIONSIMPEDANZDETEKTIONSSCHALTUNG FÜR EIN BORDLADEGERÄT UND ISOLATIONSIMPEDANZDETEKTIONSVERFAHREN

CIRCUIT DE DÉTECTION D'IMPÉDANCE D'ISOLATION POUR CHARGEUR DE BORD ET PROCÉDÉ DE DÉTECTION D'IMPÉDANCE D'ISOLATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **20.04.2020   CN 202010310174**

(43) Date of publication of application:
**27.10.2021   Bulletin 2021/43**

(73) Proprietor: **Delta Electronics (Shanghai) Co., Ltd.
Shanghai 201209 (CN)**

(72) Inventors:
  • **HAN, Xu
    Shanghai, 201209 (CN)**
  • **LIU, Yufei
    Shanghai, 201209 (CN)**
  • **WU, Haixin
    Shanghai, 201209 (CN)**
  • **YUAN, Xunyan
    Shanghai, 201209 (CN)**
  • **SUN, Hao
    Shanghai, 201209 (CN)**

(74) Representative: **SSM Sandmair
Patentanwälte Rechtsanwalt
Partnerschaft mbB
Joseph-Wild-Straße 20
81829 München (DE)**

(56) References cited:
  **CN-A- 106 483 378     US-A1- 2019 178 914**

**EP 3 901 641 B1**

**Description**

BACKGROUND OF THE INVENTION

1. Field of the Invention

The invention relates to the technical field of power electronics, and in particular, to an insulation impedance detection circuit and an insulation impedance detection method compatible with off-line and on-line detections.

2. Related Art

With continuous development of electric vehicles, mileage range of batteries is continuously increasing. Meanwhile, there is a higher demand for functions of the on-board charger, and the original unidirectional on-board charger has been developed to the bidirectional on-board charger. When operating in a discharge mode, the bidirectional on-board charger converts a high DC voltage output from a power battery pack into a user-available AC voltage, which brings more convenience to the user. As a very important component in the electric vehicle, safety and reliability of the bidirectional on-board charger play a vital role in the entire vehicle. While during the discharge mode, an AC line fault may cause damage to the electric device, even personal safety hazard. Therefore, it is necessary to perform insulation impedance detection on AC output lines of the bidirectional on-board charger.

At present, there are two methods to realize insulation impedance detection, which are on-line and off-line methods. The off-line insulation impedance detection method can detect whether there is insulation abnormity of the AC output lines before operation of the on-board charger to prevent the charger from outputting power under the condition of line fault, and causing safety hazard. While the on-line insulation impedance detection can monitor line insulation impedance in real-time, and can timely shut down the power output in the case of insulation impedance abnormity to avoid safety hazard.

The conventional insulation impedance detection technology is mainly directed to DC on-board power battery pack, which is not applicable to AC insulation impedance detection, and is incompatible with both on-line and off-line insulation impedance detections. Prior art examples teaching impedance detection are disclosed in:

US2019178914 A1 which discloses a method for monitoring an AC voltage source, which is decoupled from a reference potential and which generates an AC voltage between two AC voltage lines.

Each of the AC voltage lines is coupled to the reference potential by way of a respective capacitive voltage divider and a respective component voltage signal is tapped at the voltage dividers and at least one root mean square value signal is generated therefrom and a check is carried out to determine whether the respective root mean square value signal meets a predetermined triggering criterion. When the triggering criterion is met, a fault signal is generated.

CN106483378 A discloses a D+/D- pin parasitic impedance detection circuit in the quick charging control of USB interface mobile equipment, and a method employed in the circuit mainly comprises the following steps: setting a USB interface D-/D+ pin pair GND/VBUS parasitic impedance detection circuit in a charging controller; continuously monitoring the D-/D+ pin pair GND/VBUS insulation condition of a USB; feeding back the detection state to the charging controller at any time; enabling the charging controller to decide whether to build communication for the output of voltage and current or not according to an impedance detection result. The circuit can quickly and precisely detect the impedance between the USB interface D-/D+ pins and the impedance between the VBUS and GND, and a detection threshold value can be adjusted.

SUMMARY OF THE INVENTION

The invention provides an insulation impedance detection circuit according to claim 1 and an insulation impedance detection method for a bidirectional on-board charger compatible with both off-line and on-line detections according to claim 10 is also provided.

The invention provides an insulation impedance detection circuit for an on-board charger, comprising a voltage division circuit, a biasing circuit, an impedance matching circuit, a voltage sampling circuit and a controller. Terminals of the voltage division circuit are electrically connected to a first AC terminal and a second AC terminal of the on-board charger respectively, and are electrically connected selectively to a first terminal of the impedance matching circuit via a switch. A second terminal of the impedance matching circuit is electrically connected to a first terminal of the biasing circuit, a second terminal of the biasing circuit is grounded, and a third terminal of the impedance matching circuit is electrically connected to an input terminal of the voltage sampling circuit. An output terminal of the voltage sampling circuit is electrically connected to the controller for outputting an insulation impedance detection signal to the controller. The controller is configured to determine whether there is an insulation impedance abnormity or not depending on the

2

insulation impedance detection signal.

According to the invention, the voltage division circuit comprises a first resistor, a second resistor and the switch, wherein, two terminals of the first resistor are electrically connected to the first AC terminal and the second AC terminal of the on-board charger respectively, one terminal of the second resistor is electrically connected to one terminal of the first resistor and the other terminal is electrically connected to one terminal of the switch, and the other terminal of the switch is electrically connected to the impedance matching circuit.

In one embodiment of the invention, the voltage sampling circuit comprises a follower circuit comprising an operational amplifier, and a filter circuit comprising a third resistor and a first capacitor. An input terminal of the follower circuit is electrically connected to the third terminal of the impedance matching circuit, an output terminal of the follower circuit is electrically connected to the filter circuit, and an output terminal of the filter circuit is electrically connected to the controller.

In one embodiment of the invention, the biasing circuit comprises a bias power supply having a bias voltage. A positive terminal of the bias power supply is electrically connected to the second terminal of the impedance matching circuit, and a negative terminal of the bias power supply is grounded.

In one embodiment of the invention, when the on-board charger is in an off-line state or operates in a discharge mode, the controller computes an insulation impedance value between the first AC terminal and the ground and/or between the second AC terminal and the ground depending on the insulation impedance detection signal, the bias voltage, and circuit parameters of the voltage division circuit, the impedance matching circuit and the voltage sampling circuit, and determines that there is an insulation impedance abnormity if the insulation impedance value is smaller than a set threshold value.

In one embodiment of the invention, the voltage sampling circuit receives a signal containing both AC and DC components from the impedance matching circuit (30) when the on-board charger operates in the discharge mode.

In one embodiment of the invention, the impedance matching circuit comprises a matching resistor and a matching capacitor electrically connected in parallel.

In one embodiment of the invention, the impedance matching circuit further comprises a diode having an anode electrically connected to the input terminal of the voltage sampling circuit, and a cathode electrically connected to the first terminal of the biasing circuit.

In one embodiment of the invention, the controller is a microcontroller unit, a digital signal processor or a field-programmable gate array.

In one embodiment of the invention, the on-board charger is a bidirectional on-board charger.

To realize the above object, the invention further provides an insulation impedance detection method based on the insulation impedance detection circuit stated above, comprising when the on-board charger is in an off-line state or operates in a discharge mode: turn on the switch of the voltage division circuit, such that the voltage division circuit is electrically connected to the impedance matching circuit; outputting a first signal by the impedance matching circuit; receiving the first signal and outputting an insulation impedance detection signal to the controller by the voltage sampling circuit; and determining by the controller whether there is an insulation impedance abnormity or not depending on the insulation impedance detection signal.

In another embodiment of the invention, the insulation impedance detection method further comprises: computing, by the controller, an insulation impedance value between the first AC terminal and the ground and/or an insulation impedance value between the second AC terminal and the ground depending on the insulation impedance detection signal, the bias voltage, and circuit parameters of the voltage division circuit, the impedance matching circuit and the voltage sampling circuit.

In another embodiment of the invention, if the insulation impedance value is smaller than a set threshold value, it is determined that there is an insulation impedance abnormity.

In another embodiment of the invention, the first signal is a signal containing both AC and DC components when the on-board charger operates in the discharge mode.

In another embodiment of the invention, the step of outputting the insulation impedance detection signal depending on the first signal by the voltage sampling circuit comprises: processing an amplitude of the first signal by the voltage sampling circuit; and filtering the first signal by the voltage sampling circuit.

The insulation impedance detection circuit and detection method of the invention are compatible with both off-line detection and on-line detection, and have a low cost. Moreover, the insulation impedance detection circuit and detection method of the invention do not generate a leakage current in a charge mode, and do not affect normal operation in the charge mode.

The additional aspects and advantages of the invention are partially explained in the below description, and partially becoming apparent from the description, or can be obtained through practice of the invention.

BRIEF DESCRIPTION OF THE DRAWINGS

The exemplary embodiments are described in detail with reference to the accompanying drawings, through which the above and other features and advantages of the invention will become more apparent.

　　FIG. 1 is a schematic diagram of an insulation impedance detection circuit for a bidirectional on-board charger according to the invention.
　　FIG. 2 is a schematic diagram of a voltage division circuit of the insulation impedance detection circuit according to the invention.
　　FIG. 3 is a schematic diagram of a voltage sampling circuit of the insulation impedance detection circuit according to the invention.
　　FIG. 4 is a structural diagram of an insulation impedance detection circuit according to one preferable embodiment of the invention.
　　FIG. 5 is a flow diagram of an insulation impedance detection method of the bidirectional on-board charger according to the invention.

DETAILED EMBODIMENTS OF THE INVENTION

The exemplary embodiments will now be described more fully with reference to the accompanying drawings. However, the exemplary embodiments can be implemented in various forms and should not be understood as being limited to the embodiments set forth herein; on the contrary, these embodiments are provided so that this invention will be thorough and complete, and the conception of exemplary embodiments will be fully conveyed to those skilled in the art. In the drawings, the same reference numeral denotes the same or similar structure, so their detailed description will be omitted.

When factors/components/the like described and/or illustrated here are introduced, the phrases "one", "a(an)", "the", "said" and "at least one" refer to one or more factors/components/the like. The terms "include", "comprise" and "have" refer to an open and included meaning, and refer to additional factors/components/the like, in addition to the listed factors/components/the like. The embodiments may use relative phrases, such as, "upper" or "lower" to describe a relative relation of one signed component over another component. It should be understood that if the signed device reverses to turn upside down, the described component on an "upper" side will become a component on a "lower" side. In addition, the terms "first", "second" and the like in the claims are only used as signs, instead of numeral limitations to objects.

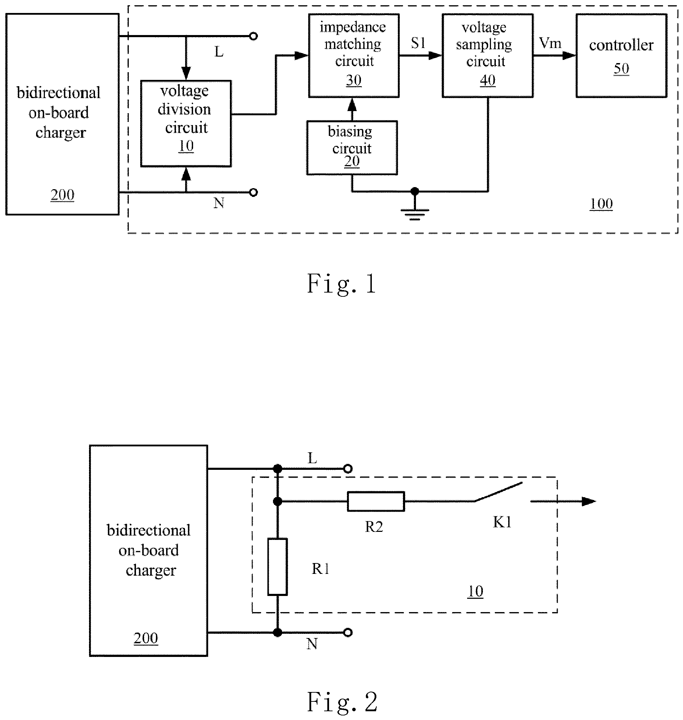

As shown in FIGS. 1-3, an insulation impedance detection circuit 100 of the invention is electrically connected to a bidirectional on-board charger 200. The insulation impedance detection circuit 100 comprises a voltage division circuit 10, a biasing circuit 20, an impedance matching circuit 30, a voltage sampling circuit 40 and a controller 50. The voltage division circuit 10 is electrically connected to a first AC terminal and a second AC terminal of the bidirectional on-board charger 200 respectively, and is also electrically connected selectively to a first terminal of the impedance matching circuit 30 via a switch K1, as shown in FIG. 2, wherein the first AC terminal is electrically connected to a live line (L line), and the second AC terminal is electrically connected to a neutral line (N line). More specifically, the switch K1 is on when the bidirectional on-board charger 200 is in an off-line state or a discharge mode, to electrically connect the voltage division circuit 10 to the impedance matching circuit 30. The switch K1 is off when the bidirectional on-board charger 200 is in a charge mode (charge the power battery pack in the electric vehicle), to disconnect the electrical connection between the voltage division circuit 10 and the impedance matching circuit 30. A second terminal of the impedance matching circuit 30 is connected to a first terminal of the biasing circuit 20, a second terminal of the biasing circuit 20 is electrically connected to the ground, that is the second terminal of the biasing circuit 20 is grounded. A third terminal of the impedance matching circuit 30 is connected to an input terminal of the voltage sampling circuit 40. An output terminal of the voltage sampling circuit 40 is electrically connected to the controller 50. The voltage sampling circuit 40 receives a first signal S1 output from the impedance matching circuit 30, processes and outputs an insulation impedance detection signal Vm to the controller 50. The controller 50 is configured to determine whether there is an insulation impedance abnormity or not depending on the insulation impedance detection signal Vm.

Preferably, as shown in FIG. 2, the voltage division circuit 10 may include, for example, a first resistor R1, a second resistor R2 and the switch K1. The first resistor R1 is electrically connected in parallel between the first AC terminal and the second AC terminal, one terminal of the second resistor R2 is electrically connected to a node between the first AC terminal and the first resistor R1, the other terminal of the second resistor R2 is electrically connected to one terminal of the switch K1, and the other terminal of the switch K1 is electrically connected to the first terminal of the impedance matching circuit 30. However, it should be understood that in other embodiments, one terminal of the second resistor R2 in the voltage division circuit 10 may also be electrically connected to a node between the second AC terminal and the first resistor R1. Further, the first resistor R1 may also be a plurality of resistors connected in series, and one terminal of the second resistor R2 is electrically connected to one of series-nodes, but the invention is not limited thereto.

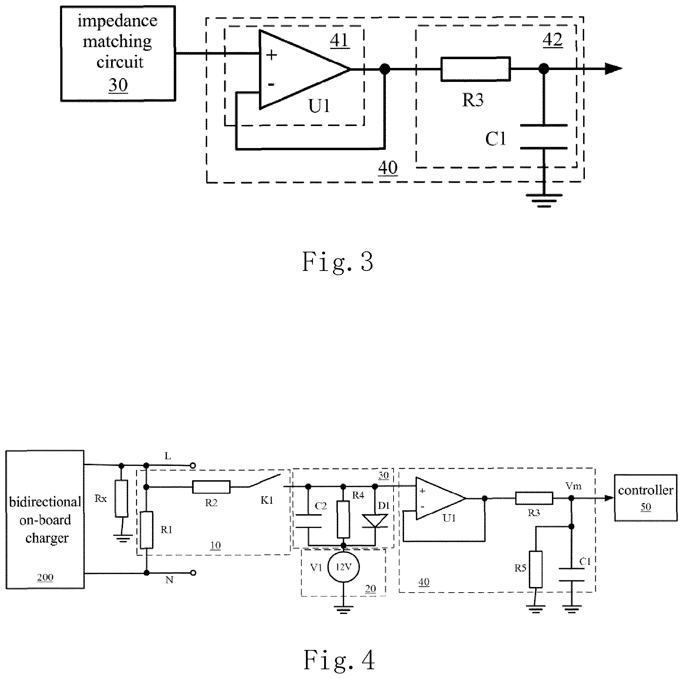

Preferably, as shown in FIG. 3, the voltage sampling circuit 40 may include, for example, a follower circuit 41 and a filter circuit 42. The follower circuit 41 may include, for example but not limited to, an operational amplifier U1. The filter circuit 42 may include, for example but not limited to, a third resistor R3 and a first capacitor C1. Moreover, an input terminal of the follower circuit 41 is electrically connected to the third terminal of the impedance matching circuit 30, an output terminal of the follower circuit 41 is electrically connected to the filter circuit 42, and an output terminal of the filter circuit 42 is electrically connected to the controller 50.

Preferably, as shown in FIG. 4 with reference to FIG. 1, the biasing circuit 20 may include, for example, a bias power supply V1 (as shown in FIG. 4) having a bias voltage of, for example, 12 V, wherein a positive terminal of the bias power supply V1 is electrically connected to the second terminal of the impedance matching circuit 30, and a negative terminal of the bias power supply V1 is electrically connected to the ground. The biasing circuit 20 may supply a bias voltage to the impedance matching circuit 30.

Preferably, as shown in FIG. 4, the impedance matching circuit 30 may include, for example, a matching resistor R4 and a matching capacitor C2 electrically connected in parallel. With a value of the matching capacitor C2 being configured reasonably, a signal input into the impedance matching circuit 30 may be filtered. Further, the impedance matching circuit 30 may also include a diode D1 having an anode electrically connected to the input terminal of the voltage sampling circuit 40, and a cathode electrically connected to the first terminal of the biasing circuit 20. The diode D1 may function to protect the operational amplifier U1 of the voltage sampling circuit 40.

In the present invention, the controller 50 may preferably be a microcontroller unit (MCU), a digital signal processor (DSP) or a field-programmable gate array (FPGA).

When the bidirectional on-board charger 200 is in an off-line state or a discharge mode, the controller 50 computes an insulation impedance value with respect to ground at the first AC terminal and/or the second AC terminal depending on the insulation impedance detection signal Vm, the bias voltage, and the parameters of the voltage division circuit 10, the impedance matching circuit 30 and the voltage sampling circuit 40. The controller 50 also determines that there is an insulation impedance abnormality if the insulation impedance value is smaller than a set threshold value. Wherein, when the bidirectional on-board charger 200 is in the discharge mode, the first signal S 1 is an superposed signal of an AC signal and a DC signal.

It should be noted that the insulation impedance detection circuit 100 of the invention is also applicable to a unidirectional on-board charger.

Hereinafter the insulation impedance detection method of the invention is described in detail taking the insulation impedance detection circuit in one preferable embodiment of FIG. 4 for example.

In FIG. 4, an impedance Rx is the insulation impedance with respect to ground at the first AC terminal of the bidirectional on-board charger 200, and the voltage signal Vm is an insulation impedance detection signal.

In FIG. 4, the first resistor R1, the second resistor R2 and the switch K1 form a voltage division circuit 10. When the bidirectional on-board charger 200 operates in a discharge mode, the switch K1 is on, and the detection circuit can be used to monitor an insulation impedance between the first AC terminal (L line) and the ground. When the bidirectional on-board charger 200 exits the discharge mode, the switch K1 is disconnected (off), and the detection circuit is removed by the switch K1 to avoid an AC leakage current.

In FIG. 4, the matching resistor R4, the matching capacitor C2 and the diode D1 form the impedance matching circuit 30 connected to the bias power supply V1 of 12V.

During off-line detection, there is no voltage output between the first AC terminal and the second AC terminal of the bidirectional on-board charger 200. At this time, the bias power supply V1 is electrically connected to the first AC terminal via the matching resistor R4, the matching capacitor C2, the diode D1 and the second resistor R2, and the series connected second resistor R2, the impedance Rx and the matching resistor R4 withstand the voltage of the bias power supply V1 together. While the matching capacitor C2 shows an open circuit and the diode D1 is reverse blocking. According to a voltage division ratio, the impedance Rx can be calculated as follows:

$$Rx = \frac{Vm \cdot R4 \cdot (R3+R5)}{V1 \cdot R5 - Vm \cdot (R3+R5)} - R2$$

If the detected impedance Rx is smaller than a set threshold value, it is determined that there is an insulation impedance abnormality. At this time, it shall be forbidden to power on, to ensure device and personal safety.

During on-line detection, when the bidirectional on-board charger 200 operates in a discharge mode, there is an AC voltage between the first AC terminal and the second AC terminal of the bidirectional on-board charger 200. The bias power supply V1 is also electrically connected to the first AC terminal via the matching resistor R4, the matching capacitor C2, the diode D1 and the second resistor R2. At this time, the matching capacitor C2 in the impedance matching circuit 30 can be used to absorb AC voltage components output from the voltage division circuit 10, and the diode D1 can be used to clamp the voltage output from the voltage division circuit 10. The first signal S1 transmitted to the voltage detection circuit 40 is a superposed signal of an AC signal and a DC signal. Filtering and voltage division functions are implemented on a signal output from the operational amplifier U1 by a third resistor R3, a fifth resistor R5 and a first capacitor C1. Finally, the insulation impedance detection signal Vm is output to the controller 50. The controller 50 may compute the impedance Rx according to the above formula, and compares with the set threshold value to determine whether there is an insulation impedance abnormity. If there is an insulation impedance abnormity, power output shall be stopped immediately, and the charger shall be turned off timely to ensure device and personal safety.

In this preferable embodiment, the methods of computing the impedance Rx in the on-line detection method and the off-line detection method are the same, and a correspondence relationship between the insulation impedance detection signal Vm obtained by the insulation impedance detection method and the computed impedance Rx, and the actual insulation impedance Rx' is shown in the table:

|  | Actual Insulation Impedance Rx' | Insulation Impedance Detection Signal Vm | Computed Insulation Impedance Rx |
|---|---|---|---|
| Off-line detection | 200k | 1.45V | 163k |
|  | 330k | 1.50V | 324k |
|  | 500k | 1.55V | 498k |
| On-line detection | 200k | 1.45V | 163k |
|  | 330k | 1.49V | 291k |
|  | 500k | 1.53V | 427k |

As can be seen from the above table, in the off-line and on-line states, an error of the insulation impedance obtained by the insulation impedance detection method of this embodiment is as small as less than 18%, which satisfies the design requirements.

In the present invention, the method shown in FIG. 4 can compute the insulation impedance between the first AC terminal and the ground, and can further compute the insulation impedance between the second AC terminal and the ground in combination with the first resistor R1, so as to determine whether there is an insulation impedance abnormity.

In the present invention, when the bidirectional on-board charger 200 operates in the charge mode, the switch K1 is off to prevent the insulation impedance detection circuit from generating a leakage current, so as to ensure the bidirectional on-board charger 200 operate normally in the charge mode.

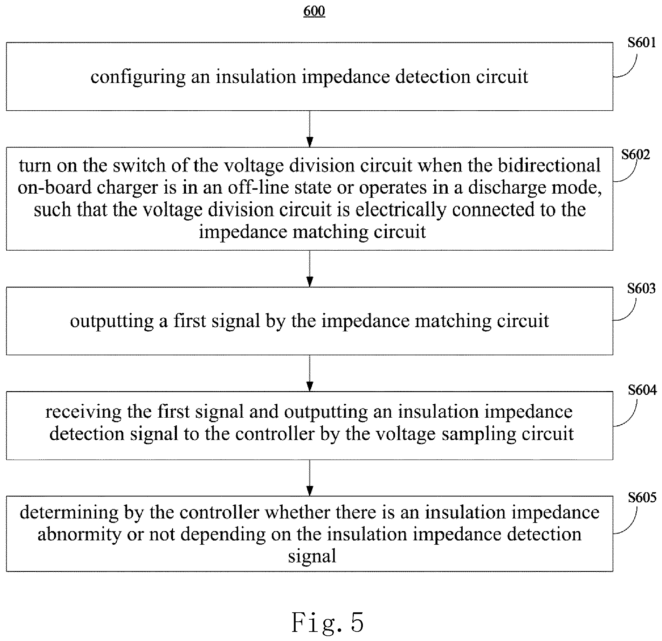

As shown in FIG. 5 with reference to FIGS. 1 and 4, the present invention provides an insulation impedance detection method 600 for the bidirectional on-board charger, which includes:

Step S601, configuring an insulation impedance detection circuit 100;
Step S602, turn on the switch K1 of the voltage division circuit 10 when the bidirectional on-board charger 200 is in an off-line state or operates in a discharge mode, such that the voltage division circuit 10 is electrically connected to the impedance matching circuit 30;
Step S603, outputting a first signal S1 by the impedance matching circuit 30; and
Step S604, receiving the first signal S1 by the voltage sampling circuit, and outputting an insulation impedance detection signal Vm to the controller 50;
Step S605, determining by the controller 50 whether there is an insulation impedance abnormity or not depending on the insulation impedance detection signal Vm.

Preferably, when the bidirectional on-board charger 200 is in an off-line state or a discharge mode, the controller 50 computes an insulation impedance value with respect to ground at the first AC terminal and/or the second AC terminal of the bidirectional on-board charger 200 depending on the insulation impedance detection signal Vm, the bias voltage, and the circuit parameters of the voltage division circuit 10, the impedance matching circuit 30 and the voltage sampling circuit 40, and determines that there is an insulation impedance abnormity if the insulation impedance value is smaller than a set threshold value.

Preferably, the process in which the voltage sampling circuit 40 outputs the insulation impedance detection signal Vm depending on the first signal S1 comprises: processing an amplitude of the first signal S1 by the voltage sampling circuit 40; and filtering the first signal S1 by the voltage sampling circuit 40.

The insulation impedance detection circuit and the insulation impedance detection method of the invention can be compatible with both off-line detection and on-line detection, and have a low cost. Moreover, the insulation impedance detection circuit and the insulation impedance detection method of the invention may not generate a leakage current in a charge mode, and do not affect normal operation in the charge mode.

**Claims**

1. An insulation impedance detection circuit (100) for an on-board charger (200), comprising a voltage division circuit (10), a biasing circuit (20), an impedance matching circuit (30), a voltage sampling circuit (40) and a controller (50), wherein,

   terminals of the voltage division circuit (10) are electrically connectable to a first AC terminal and a second AC terminal of the on-board charger (200) respectively, and are electrically connected selectively to a first terminal of the impedance matching circuit (30);
   a second terminal of the impedance matching circuit (30) is electrically connected to a first terminal of the biasing circuit (20), a second terminal of the biasing circuit (20) is grounded, and a third terminal of the impedance matching circuit (30) is electrically connected to an input terminal of the voltage sampling circuit (40);
   an output terminal of the voltage sampling circuit (40) is electrically connected to the controller (50) for outputting an insulation impedance detection signal (Vm) to the controller (50); and
   the controller (50) is configured to determine whether there is an insulation impedance abnormity or not depending on the insulation impedance detection signal (Vm); and
   wherein the insulation impedance detection circuit (100) is **characterized in that**
   the terminals of the voltage division circuit (10) are electrically connected selectively to the first terminal of the impedance matching circuit (30) via a switch (K1); and wherein the voltage division circuit (10) comprises a first resistor (R1), a second resistor (R2) and the switch (K1), wherein, two terminals of the first resistor (R1) are electrically connectable to the first AC terminal and the second AC terminal of the on-board charger (200) respectively, one terminal of the second resistor (R2) is electrically connected to one terminal of the first resistor (R1) and another terminal is electrically connected to one terminal of the switch (K1), and another terminal of the switch (K1) is electrically connected to the impedance matching circuit (30).

2. The insulation impedance detection circuit (100) according to claim 1, **characterized in that** the voltage sampling circuit (40) comprises a follower circuit (41) comprising an operational amplifier (U1), and a filter circuit (42) comprising a third resistor (R3) and a first capacitor (C1), wherein an input terminal of the follower circuit (41) is electrically connected to the third terminal of the impedance matching circuit (30), an output terminal of the follower circuit (41) is electrically connected to the filter circuit (42), and an output terminal of the filter circuit (42) is electrically connected to the controller (50).

3. The insulation impedance detection circuit (100) according to claim 1, **characterized in that** the biasing circuit (20) comprises a bias power supply (V1) having a bias voltage, wherein a positive terminal of the bias power supply (V1) is electrically connected to the second terminal of the impedance matching circuit (30), and a negative terminal of the bias power supply (V1) is grounded.

4. The insulation impedance detection circuit (100) according to claim 3, **characterized in that** when the on-board charger (200) is in an off-line state or operates in a discharge mode, the controller (50) computes an insulation impedance value between the first AC terminal and the ground and/or between the second AC terminal and the ground depending on the insulation impedance detection signal (Vm), the bias voltage, and circuit parameters of the voltage division circuit (10), the impedance matching circuit (30) and the voltage sampling circuit (40), and determines that there is an insulation impedance abnormity if the insulation impedance value is smaller than a set threshold value.

5. The insulation impedance detection circuit (100) according to claim 4, **characterized in that** the voltage sampling circuit (40) receives a signal containing both AC and DC components from the impedance matching circuit (30) when the on-board charger (200) operates in the discharge mode.

6. The insulation impedance detection circuit (100) according to claim 1, **characterized in that** the impedance matching circuit (30) comprises a matching resistor (R4) and a matching capacitor (C2) electrically connected in parallel.

7. The insulation impedance detection circuit (100) according to claim 6, **characterized in that** the impedance matching circuit (30) further comprises a diode (D1) having an anode electrically connected to the input terminal of the voltage sampling circuit (40) and a cathode electrically connected to the first terminal of the biasing circuit (20).

8. The insulation impedance detection circuit (100) according to claim 1, **characterized in that** the controller (50) is a microcontroller unit, a digital signal processor or a field-programmable gate array.

9. The insulation impedance detection circuit (100) according to claim 1, **characterized in that** the on-board charger (200) is a bidirectional on-board charger.

10. An insulation impedance detection method (600) fusing the insulation impedance detection circuit (100) according to any one of claims 1 to 9, **characterized in that** the method comprises:
when the on-board charger (200) is in an off-line state or operates in a discharge mode:

   turn on (S602) the switch (K1) of the voltage division circuit (10), such that the voltage division circuit (10) is electrically connected to the impedance matching circuit (30);
   outputting (S603) a first signal (S1) by the impedance matching circuit (30);
   receiving (S604) the first signal (S1) and outputting an insulation impedance detection signal (Vm) to the controller (50) by the voltage sampling circuit (40); and
   determining (S605), by the controller (50), whether there is an insulation impedance abnormity depending on the insulation impedance detection signal (Vm).

11. The insulation impedance detection method (600) according to claim 10, **characterized in**:
computing, by the controller (50), an insulation impedance value between the first AC terminal and the ground and/or an insulation impedance value between the second AC terminal and the ground depending on the insulation impedance detection signal (Vm), the bias voltage, and circuit parameters of the voltage division circuit (10), the impedance matching circuit (30) and the voltage sampling circuit (40).

12. The insulation impedance detection method (600) according to claim 11, **characterized in** determining that there is an insulation impedance abnormity when the insulation impedance value is smaller than a set threshold value.

13. The insulation impedance detection method (600) according to claim 11, **characterized in that** the first signal (S1) is a signal containing both AC and DC components when the on-board charger (200) operates in the discharge mode.

14. The insulation impedance detection method (600) according to claim 10, **characterized in that** outputting (S604) the insulation impedance detection signal (Vm) comprises:

   processing an amplitude of the first signal (S1) by the voltage sampling circuit (30); and
   filtering the first signal (S1) by the voltage sampling circuit (30).

**Patentansprüche**

1. Eine Isolationsimpedanz-Erfassungsschaltung (100) für ein Bordladegerät (200), die eine Spannungsteilungsschaltung (10), eine Vorspannungsschaltung (20), eine Impedanzanpassungsschaltung (30), eine Spannungsabtastschaltung (40) und eine Steuerung (50) umfasst, wobei,

   Anschlüsse der Spannungsteilungsschaltung (10) mit einem ersten Wechselstromanschluss beziehungsweise einem zweiten Wechselstromanschluss des Bordladegeräts (200) elektrisch verbindbar sind und selektiv mit einem ersten Anschluss der Impedanzanpassungsschaltung (30) elektrisch verbunden sind;
   ein zweiter Anschluss der Impedanzanpassungsschaltung (30) elektrisch mit einem ersten Anschluss der Vorspannungsschaltung (20) verbunden ist, ein zweiter Anschluss der Vorspannungsschaltung (20) geerdet ist, und ein dritter Anschluss der Impedanzanpassungsschaltung (30) elektrisch mit einem Eingangsanschluss der Spannungsabtastschaltung (40) verbunden ist;
   ein Ausgangsanschluss der Spannungsabtastschaltung (40) elektrisch mit dem Steuergerät (50) verbunden ist, um ein Isolationsimpedanz-Erfassungssignal (Vm) an das Steuergerät (50) auszugeben; und
   die Steuerung (50) so konfiguriert ist, dass sie in Abhängigkeit von dem Isolationsimpedanz-Erfassungssignal (Vm) bestimmt, ob eine Isolationsimpedanz-Anomalie vorliegt oder nicht; und
   wobei die Isolationsimpedanz-Erfassungseinheit (100) **dadurch gekennzeichnet ist, dass**

die Anschlüsse der Spannungsteilungsschaltung (10) selektiv mit ersten Anschlüssen der Impedanzanpassungsschaltung (30) über einen Schalter (K1) elektrisch verbunden sind; und wobei

die Spannungsteilungsschaltung (10) einen ersten Widerstand (R1), einen zweiten Widerstand (R2) und den Schalter (K1) umfasst, wobei zwei Anschlüsse des ersten Widerstands (R1) elektrisch mit dem ersten Wechselstromanschluss beziehungsweise dem zweiten Wechselstromanschluss des Bordladegeräts (200) verbunden werden können, ein Anschluss des zweiten Widerstands (R2) elektrisch mit einem Anschluss des ersten Widerstands (R1) verbunden ist und ein anderer Anschluss elektrisch mit einem Anschluss des Schalters (K1) verbunden ist, und ein anderer Anschluss des Schalters (K1) elektrisch mit der Impedanzanpassungsschaltung (30) verbunden ist.

2. Die Isolationsimpedanz-Erfassungsschaltung (100) nach Anspruch 1, **dadurch gekennzeichnet, dass** die Spannungsabtastschaltung (40) eine Folgerschaltung (41) mit einem Operationsverstärker (U1) und eine Filterschaltung (42) mit einem dritten Widerstand (R3) und einem ersten Kondensator (C1) umfasst, wobei ein Eingangsanschluss der Folgerschaltung (41) elektrisch mit dem dritten Anschluss der Impedanzanpassungsschaltung (30) verbunden ist, ein Ausgangsanschluss der Folgerschaltung (41) elektrisch mit der Filterschaltung (42) verbunden ist und ein Ausgangsanschluss der Filterschaltung (42) elektrisch mit der Steuerung (50) verbunden ist.

3. Die Isolationsimpedanz-Erfassungsschaltung (100) nach Anspruch 1, **dadurch gekennzeichnet, dass** die Vorspannungsschaltung (20) eine Vorspannungsstromversorgung (V1) mit einer Vorspannung umfasst, wobei ein positiver Anschluss der Vorspannungsstromversorgung (V1) elektrisch mit dem zweiten Anschluss der Impedanzanpassungsschaltung (30) verbunden ist und ein negativer Anschluss der Vorspannungsstromversorgung (V1) geerdet ist.

4. Die Isolationsimpedanz-Erfassungsschaltung (100) nach Anspruch 3, **dadurch gekennzeichnet, dass**, wenn sich das Bordladegerät (200) in einem Offline-Zustand befindet oder in einem Entladungsmodus arbeitet, die Steuerung (50) einen Isolationsimpedanzwert zwischen dem ersten Wechselstromanschluss und der Masse und/oder zwischen dem zweiten Wechselstromanschluss und der Masse berechnet, abhängig von dem Isolationsimpedanz-Erfassungssignal (Vm), der Vorspannung und den Schaltungsparametern der Spannungsteilungsschaltung (10), der Impedanzanpassungsschaltung (30) und der Spannungsabtastschaltung (40), und bestimmt, dass eine Isolationsimpedanzanomalie vorliegt, wenn der Isolationsimpedanzwert kleiner als ein eingestellter Schwellenwert ist.

5. Die Isolationsimpedanz-Erfassungsschaltung (100) nach Anspruch 4, **dadurch gekennzeichnet, dass** die Spannungsabtastschaltung (40) ein Signal, das sowohl Wechsel- als auch Gleichstromkomponenten enthält, von der Impedanzanpassungsschaltung (30) empfängt, wenn das Bordladegerät (200) im Entladungsmodus arbeitet.

6. Die Isolationsimpedanz-Erfassungsschaltung (100) nach Anspruch 1, **dadurch gekennzeichnet, dass** die Impedanzanpassungsschaltung (30) einen Anpassungswiderstand (R4) und einen Anpassungskondensator (C2) umfasst, die elektrisch parallel geschaltet sind.

7. Die Isolationsimpedanz-Erfassungsschaltung (100) nach Anspruch 6, **dadurch gekennzeichnet, dass** die Impedanzanpassungsschaltung (30) ferner eine Diode (D1) umfasst, deren Anode elektrisch mit dem Eingangsanschluss der Spannungsabtastschaltung (40) und deren Kathode elektrisch mit dem ersten Anschluss der Vorspannungsschaltung (20) verbunden ist.

8. Die Isolationsimpedanz-Erfassungsschaltung (100) nach Anspruch 1, **dadurch gekennzeichnet, dass** die Steuerung (50) eine Mikrocontroller-Einheit, ein digitaler Signalprozessor oder ein feldprogrammierbares Gate-Array ist.

9. Die Isolationsimpedanz-Erfassungsschaltung (100) nach Anspruch 1, **dadurch gekennzeichnet, dass** das Bordladegerät (200) ein bidirektionales Bordladegerät ist.

10. Ein Isolationsimpedanz-Erfassungsverfahren (600) unter Verwendung der Isolationsimpedanz-Erfassungsschaltung (100) nach einem der Ansprüche 1 bis 9, **dadurch gekennzeichnet, dass** das Verfahren Folgendes umfasst: wenn sich das Bordladegerät (200) in einem Offline-Zustand befindet oder in einem Entladungsmodus arbeitet:

das Einschalten (S602) des Schalters (K1) der Spannungsteilungsschaltung (10), so dass die Spannungsteilungsschaltung (10) elektrisch mit der Impedanzanpassungsschaltung (30) verbunden ist;
das Ausgeben (S603) eines ersten Signals (S1) durch die Impedanzanpassungsschaltung (30);
das Empfangen (S604) des ersten Signals (S1) und das Ausgeben eines Isolationsimpedanz-Erfassungssignals (Vm) an die Steuerung (50) durch die Spannungsabtastschaltung (40); und
das Bestimmen (S605) durch die Steuerung (50), ob eine Isolationsimpedanzanomalie vorliegt, abhängig von dem Isolationsimpedanz-Erfassungssignal (Vm).

**11.** Das Isolationsimpedanz-Erfassungsverfahren (600) nach Anspruch 10, **gekennzeichnet durch**:
das Berechnen eines Isolationsimpedanzwertes zwischen dem ersten Wechselstromanschluss und der Masse und/oder eines Isolationsimpedanzwertes zwischen dem zweiten Wechselstromanschluss und der Masse in Abhängigkeit von dem Isolationsimpedanz-Erfassungssignal (Vm), der Vorspannung und den Schaltungsparametern der Spannungsteilerschaltung (10), der Impedanzanpassungsschaltung (30) und der Spannungsabtastschaltung (40) durch die Steuereinheit (50).

**12.** Das Isolationsimpedanz-Erfassungsverfahren (600) nach Anspruch 11, **dadurch gekennzeichnet, dass** festgestellt wird, dass eine Isolationsimpedanzanomalie vorliegt, wenn der Isolationsimpedanzwert kleiner als ein eingestellter Schwellenwert ist.

**13.** Das Isolationsimpedanz-Erfassungsverfahren (600) nach Anspruch 11, **dadurch gekennzeichnet, dass** das erste Signal (S1) ein Signal ist, das sowohl Wechsel- als auch Gleichstromkomponenten enthält, wenn das Bordladegerät (200) im Entladungsmodus arbeitet.

**14.** Das Isolationsimpedanz-Erfassungsverfahren (600) nach Anspruch 10, **dadurch gekennzeichnet, dass** das Ausgeben (S604) des Isolationsimpedanz-Erfassungssignals (Vm) umfasst:

das Verarbeiten einer Amplitude des ersten Signals (S1) durch die Spannungsabtastschaltung (30); und
das Filtern des ersten Signals (S1) durch die Spannungsabtastschaltung (30).

**Revendications**

**1.** Circuit de détection d'impédance d'isolation (100) pour un chargeur à bord (200), comprenant un circuit de division de tension (10), un circuit de polarisation (20), un circuit d'adaptation d'impédance (30), un circuit d'échantillonnage de tension (40) et un contrôleur (50), dans lequel,

des bornes du circuit de division de tension (10) sont électriquement connectables à une première borne CA et une seconde borne CA du chargeur à bord (200) respectivement, et sont électriquement connectées sélectivement à une première borne du circuit d'adaptation d'impédance (30) ;
une deuxième borne du circuit d'adaptation d'impédance (30) est électriquement connectée à une première borne du circuit de polarisation (20), une seconde borne du circuit de polarisation (20) est mise à la terre, et une troisième borne du circuit d'adaptation d'impédance (30) est électriquement connectée à une borne d'entrée du circuit d'échantillonnage de tension (40) ;
une borne de sortie du circuit d'échantillonnage de tension (40) est électriquement connectée au contrôleur (50) pour envoyer en sortie un signal de détection d'impédance d'isolation (Vm) au contrôleur (50) ; et
le contrôleur (50) est configuré pour déterminer le fait qu'il y a une anomalie d'impédance d'isolation ou non, en fonction du signal de détection d'impédance d'isolation (Vm) ; et
dans lequel le circuit de détection d'impédance d'isolation (100) est **caractérisé en ce que**
les bornes du circuit de division de tension (10) sont électriquement connectées sélectivement à la première borne du circuit d'adaptation d'impédance (30) par l'intermédiaire d'un commutateur (K1) ; et dans lequel le circuit de division de tension (10) comprend une première résistance (R1), une deuxième résistance (R2) et le commutateur (K1), dans lequel, deux bornes de la première résistance (R1) sont électriquement connectables à la première borne CA et la seconde borne CA du chargeur à bord (200) respectivement, une borne de la deuxième résistance (R2) est électriquement connectée à une borne de la première résistance (R1) et une autre borne est électriquement connectée à une borne du commutateur (K1), et une autre borne du commutateur (K1) est électriquement connectée au circuit d'adaptation d'impédance (30).

**2.** Circuit de détection d'impédance d'isolation (100) selon la revendication 1, **caractérisé en ce que** le circuit d'échantillonnage de tension (40) comprend un circuit asservi (41) comprenant un amplificateur fonctionnel (U1), et un circuit filtre (42) comprenant une troisième résistance (R3) et un premier condensateur (C1), dans lequel une borne d'entrée du circuit asservi (41) est électriquement connectée à la troisième borne du circuit d'adaptation d'impédance (30), une borne de sortie du circuit asservi (41) est électriquement connectée au circuit filtre (42), et une borne de sortie du circuit filtre (42) est électriquement connectée au contrôleur (50).

3.  Circuit de détection d'impédance d'isolation (100) selon la revendication 1, **caractérisé en ce que** le circuit de polarisation (20) comprend une alimentation électrique de polarisation (V1) ayant une tension de polarisation, dans lequel une borne positive de l'alimentation électrique de polarisation (V1) est électriquement connectée à la deuxième borne du circuit d'adaptation d'impédance (30), et une borne négative de l'alimentation électrique de polarisation (V1) est mise à la terre.

4.  Circuit de détection d'impédance d'isolation (100) selon la revendication 3, **caractérisé en ce que**, lorsque le chargeur à bord (200) est dans un état hors ligne ou fonctionne dans un mode de décharge, le contrôleur (50) calcule une valeur d'impédance d'isolation entre la première borne CA et la terre et/ou entre la seconde borne CA et la terre, en fonction du signal de détection d'impédance d'isolation (Vm), de la tension de polarisation, et de paramètres de circuit du circuit de division de tension (10), du circuit d'adaptation d'impédance (30) et du circuit d'échantillonnage de tension (40), et détermine qu'il y a une anomalie d'impédance d'isolation si la valeur d'impédance d'isolation est inférieure à une valeur seuil définie.

5.  Circuit de détection d'impédance d'isolation (100) selon la revendication 4, **caractérisé en ce que** le circuit d'échantillonnage de tension (40) reçoit un signal contenant des composantes à la fois CA et CC à partir du circuit d'adaptation d'impédance (30) lorsque le chargeur à bord (200) fonctionne dans le mode de décharge.

6.  Circuit de détection d'impédance d'isolation (100) selon la revendication 1, **caractérisé en ce que** le circuit d'adaptation d'impédance (30) comprend une résistance d'adaptation (R4) et un condensateur d'adaptation (C2) électriquement connectés en parallèle.

7.  Circuit de détection d'impédance d'isolation (100) selon la revendication 6, **caractérisé en ce que** le circuit d'adaptation d'impédance (30) comprend en outre une diode (D1) ayant une anode électriquement connectée à la borne d'entrée du circuit d'échantillonnage de tension (40) et une cathode électriquement connectée à la première borne du circuit de polarisation (20).

8.  Circuit de détection d'impédance d'isolation (100) selon la revendication 1, **caractérisé en ce que** le contrôleur (50) est une unité microcontrôleur, un processeur de signal numérique ou un réseau prédiffusé programmable par l'utilisateur.

9.  Circuit de détection d'impédance d'isolation (100) selon la revendication 1, **caractérisé en ce que** le chargeur à bord (200) est un chargeur à bord bidirectionnel.

10. Procédé de détection d'impédance d'isolation (600) utilisant le circuit de détection d'impédance d'isolation (100) selon l'une quelconque des revendications 1 à 9, **caractérisé en ce que** le procédé comprend :
    lorsque le chargeur à bord (200) est dans un état hors ligne ou fonctionne dans un mode de décharge :

    l'allumage (S602) du commutateur (K1) du circuit de division de tension (10), de telle sorte que le circuit de division de tension (10) soit électriquement connecté au circuit d'adaptation d'impédance (30) ;
    l'envoi en sortie (S603) d'un premier signal (S1) par le circuit d'adaptation d'impédance (30) ;
    la réception (S604) du premier signal (S1) et l'envoi en sortie d'un signal de détection d'impédance d'isolation (Vm) au contrôleur (50) par le circuit d'échantillonnage de tension (40) ; et
    la détermination (S605), par le contrôleur (50), du fait qu'il y a une anomalie d'impédance d'isolation ou non, en fonction du signal de détection d'impédance d'isolation (Vm).

11. Procédé de détection d'impédance d'isolation (600) selon la revendication 10, **caractérisé par** :
    le calcul, par le contrôleur (50), d'une valeur d'impédance d'isolation entre la première borne CA et la terre et/ou une valeur d'impédance d'isolation entre la seconde borne CA et la terre, en fonction du signal de détection d'impédance d'isolation (Vm), de la tension de polarisation, et de paramètres de circuit du circuit de division de tension (10), du circuit d'adaptation d'impédance (30) et du circuit d'échantillonnage de tension (40).

12. Procédé de détection d'impédance d'isolation (600) selon la revendication 11, **caractérisé par** la détermination qu'il y a une anomalie d'impédance d'isolation lorsque la valeur d'impédance d'isolation est inférieure à une valeur seuil définie.

**13.** Procédé de détection d'impédance d'isolation (600) selon la revendication 11, **caractérisé en ce que** le premier signal (S1) est un signal contenant des composantes à la fois CA et CC lorsque le chargeur à bord (200) fonctionne dans le mode de décharge.

**14.** Procédé de détection d'impédance d'isolation (600) selon la revendication 10, **caractérisé en ce que** l'envoi en sortie (S604) du signal de détection d'impédance d'isolation (Vm) comprend :

le traitement d'une amplitude du premier signal (S1) par le circuit d'échantillonnage de tension (30) ; et
le filtrage du premier signal (S1) par le circuit d'échantillonnage de tension (30).

Fig. 1

Fig. 2

Fig. 3

Fig. 4

600

configuring an insulation impedance detection circuit

S601

turn on the switch of the voltage division circuit when the bidirectional on-board charger is in an off-line state or operates in a discharge mode, such that the voltage division circuit is electrically connected to the impedance matching circuit

S602

outputting a first signal by the impedance matching circuit

S603

receiving the first signal and outputting an insulation impedance detection signal to the controller by the voltage sampling circuit

S604

determining by the controller whether there is an insulation impedance abnormity or not depending on the insulation impedance detection signal

S605

Fig. 5

**EP 3 901 641 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2019178914 A1
- CN 106483378 A